# EUROPÄISCHE PATENTSCHRIFT

(11) **EP 2 612 539 B1**
(45) Veröffentlichungstag und Bekanntmachung des Hinweises auf die Patenterteilung: **04.04.2018**
(21) Anmeldenummer: 11763991.4
(22) Anmeldetag: 15.08.2011
(51) Int. Cl.: H05B 6/12, H05K 9/00

(54) **HAUSGERÄTEVORRICHTUNG**
DOMESTIC APPLIANCE
APPAREIL MÉNAGER

(30) Priorität: 30.08.2010 ES 201031293 P
(43) Veröffentlichungstag der Anmeldung: 10.07.2013
(73) Patentinhaber: BSH Hausgeräte GmbH, 81739 München (DE)
(72) Erfinder: CUARTIELLES RUIZ, Diego, E-50012 Zaragoza (ES); LORENTE PEREZ, Alfonso, E-50019 Zaragoza (ES); PARICIO AZCONA, Jose Joaquin, E-50019 Zaragoza (ES)
(86) Internationale Anmeldenummer: PCT/IB2011/053603
(87) Internationale Veröffentlichungsnummer: WO 2012/028984

(56) Entgegenhaltungen:
- EP-A1- 0 713 349
- WO-A1-2009/071413
- WO-A2-02/17684
- CN-Y- 201 341 297
- DE-A1- 10 011 773
- DE-U1- 20 214 073

## Beschreibung

Die Erfindung geht aus von einer Hausgerätevorrichtung nach dem Oberbegriff des Anspruchs 1. Eine derartige gattungsgemäße Hausgerätevorrichtung ist beispielweise aus der DE 100 11 773 A bekannt. Es ist eine Hausgerätevorrichtung für ein Induktionskochfeld bekannt, die über zwei metallische Hauptfunktionsbauteile verfügt, wobei ein erstes Hauptfunktionsbauteil ein Außengehäuse des Induktionskochfelds und ein zweites Hauptfunktionsbauteil eine Trägerplatte für eine Heizeinheit bildet. Aufgrund gesetzlicher Vorschriften bei Geräten der Schutzklasse I ist das erste Hauptfunktionsbauteil direkt mit einem Schutzleiteranschluss einer Hauptspannungsversorgung verbunden. Zur Einhaltung von Grenzwerten einer Elektromagnetischen Verträglichkeit (EMV) ist das zweite Hauptfunktionsbauteil über zwei Hauptentstörungsleitungen und eine EMV-Filtereinheit mit dem Schutzleiteranschluss verbunden, wobei eine erste Hauptentstörungsleitung das erste Hauptfunktionsbauteil mit einem ersten Anschluss der EMV-Filtereinheit und eine zweite Hauptentstörungsleitung einen zweiten Anschluss der EMV-Filtereinheit mit dem zweiten Hauptfunktionsbauteil verbindet.
Die Aufgabe der Erfindung besteht insbesondere darin, eine gattungsgemäße Hausgerätevorrichtung mit verbesserten Eigenschaften hinsichtlich einer einfachen Montage und eines geringen Materialbedarfs bereitzustellen. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.
Die Erfindung geht aus von einer Hausgerätevorrichtung mit einem metallischen ersten Hauptfunktionsbauteil, zumindest einem metallischen zweiten Hauptfunktionsbauteil, zumindest zwei Hauptentstörungsleitungen und einer EMV-Filtereinheit, die zumindest zu einer Entstörung über eine Hauptentstörungsleitung mit dem ersten Hauptfunktionsbauteil und über eine Hauptentstörungsleitung mit dem zweiten Hauptfunktionsbauteil verbunden ist.

Es wird vorgeschlagen, dass die Hauptentstörungsleitungen zumindest teilweise einstückig ausgebildet sind. Unter einem "Hauptfunktionsbauteil" soll insbesondere ein Bauteil mit einer Masse von zumindest 25 g, insbesondere von mindestens 50 g, vorzugsweise von wenigstens 100 g und besonders vorteilhaft von zumindest 500 g verstanden werden. Insbesondere ist das Hauptfunktionsbauteil eine Abdeckung und/oder ein Träger, wie insbesondere ein Heizeinheitsträger. Das Hauptfunktionsbauteil kann insbesondere aus mehreren Einzelelementen zusammengesetzt sein. Unter einer "Hauptentstörungsleitung" soll insbesondere eine für Wechselstromsignale leitfähige Verbindung zwischen einem zu entstörenden Bauteil und einer EMV-Filtereinheit verstanden werden, die insbesondere elektrische Leitungen und/oder andere Bauteile, insbesondere zumindest ein Hauptfunktionsbauteil, umfasst. Insbesondere ist die Hauptentstörungsleitung dazu vorgesehen, einen Hauptteil aller, von einem zu entstörenden Bauteil zu der EMV-Filtereinheit übertragenen Wechselstromsignale zu übertragen. Unter einem "Hauptteil aller Wechselstromsignale" sollen insbesondere zumindest 50%, vorzugsweise wenigstens 70% und besonders vorteilhaft mindestens 90% einer Gesamtleistung und/oder eines effektiven Gesamtstroms aller übertragenen Wechselstromsignale verstanden werden. Unter einer "elektrischen Leitung" soll insbesondere eine für Gleichstromsignale leitfähige Verbindung zwischen wenigstens zwei Punkten und besonders vorteilhaft zwischen genau zwei Punkten verstanden werden, die durch zumindest ein Kabel und/oder wenigstens eine Leiterbahn und/oder zumindest eine elektrische Anschlussstelle gebildet ist. Unter einer "elektrischen Anschlussstelle" soll insbesondere eine für Gleichstromsignale leitfähige Verbindung zwischen einer elektrischen Leitung, insbesondere einem Kabel, und einem weiteren Bauteil, insbesondere einem Hauptfunktionsbauteil, oder einer weiteren elektrischen Leitung, insbesondere einer Leiterbahn, verstanden werden. Unter einer "EMV-Filtereinheit" soll insbesondere eine elektrische Einheit verstanden werden, die dazu vorgesehen ist, Wechselstromsignale und vorzugsweise hochfrequente Störsignale in ihrer Amplitude um zumindest 20%, insbesondere um wenigstens 40% und vorteilhaft um mindestens 60% abzuschwächen und besonders vorteilhaft, die elektrische Energie in Wärme umzuwandeln und/oder hochfrequente Störsignale mit einem Funktionserdungsanschluss kurzzuschließen. Unter einem "hochfrequenten Störsignal" soll insbesondere ein schwaches Wechselstromsignal mit einer Spannung von höchstens 1 V, insbesondere von höchstens 100 mV und besonders vorteilhaft von höchstens 10 mV und einer Frequenz von zumindest 100 kHz, insbesondere von wenigstens 1 MHz, vorzugsweise von zumindest 2 MHz und besonders vorteilhaft von mindestens 3 MHz verstanden werden. Vorzugsweise umfasst die EMV-Filtereinheit zumindest einen Kondensator, insbesondere einen mit einem Funktionserdungsanschluss verbundenen Y-Kondensator, und/oder eine Drosselspule. Unter einer "Entstörung" soll insbesondere eine Abschwächung einer Amplitude eines hochfrequenten Störsignals um zumindest 20%, insbesondere um wenigstens 40% und vorteilhaft um mindestens 60% und besonders vorteilhaft unter eine gesetzlich vorgeschriebene und/oder durch Normen, insbesondere durch den Standard CISPR 11, definierte Signalobergrenze verstanden werden. Darunter, dass die Hauptentstörungsleitungen "zumindest teilweise einstückig" ausgebildet sind, soll verstanden werden, dass die Hauptentstörungsleitungen zumindest einen gemeinsamen Teilbereich aufweisen. Insbesondere kann der Teilbereich auch mit einer der Hauptentstörungsleitungen identisch sein. Dadurch, dass die Hauptentstörungsleitungen zumindest teilweise einstückig ausgebildet sind, kann eine vorteilhaft einfache Montage erreicht werden. Des Weiteren können Material, Bauraum und Kosten eingespart werden.

Besonders vorteilhaft ist zumindest eines der zwei Hauptfunktionsbauteile geerdet. Darunter, dass ein Bauteil "geerdet" ist, soll insbesondere verstanden werden, dass das Bauteil über wenigstens eine elektrische Leitung mit einem Schutzleiteranschluss einer Hauptspannungsversorgung verbunden ist. Hierdurch kann eine Schutz- und/oder Funktionserdung erreicht werden.

In einer bevorzugten Ausgestaltung wird vorgeschlagen, dass die Hausgerätevorrichtung einen Leitungsknoten umfasst, der die EMV-Filtereinheit, einen Schutzleiteranschluss einer Hauptspannungsversorgung und das erste Hauptfunktionsbauteil verknüpft. Unter einem "Leitungsknoten" soll insbesondere eine elektrische Leitung zwischen drei Punkten verstanden werden, die einen Knotenpunkt aufweist, an dem drei elektrische Leitungen zusammentreffen, welche jeweils den Knotenpunkt mit jeweils genau einem der drei Punkte verbinden. Darunter, dass der Leitungsknoten die EMV-Filtereinheit, den Schutzleiteranschluss und das erste Hauptfunktionsbauteil "verknüpft", soll insbesondere verstanden werden, dass der Leitungsknoten die EMV-Filtereinheit, den Schutzleiteranschluss und das erste Hauptfunktionsbauteil sternförmig elektrisch leitend verbindet. Hierdurch kann gewährleistet werden, dass Störsignale auf dem geerdeten ersten Hauptfunktionsbauteil mittels der EMV-Filtereinheit zu einem Großteil gefiltert werden.

Ferner wird vorgeschlagen, dass die zwei Hauptfunktionsbauteile im Wesentlichen durch eine Beabstandung zumindest für Wechselstromsignale elektrisch gekoppelt sind. Unter einer "Beabstandung" soll insbesondere eine geometrische Orientierung der zwei Hauptfunktionsbauteile zueinander und/oder ein elektrisch leitendes Abstandselement zwischen den zwei Hauptfunktionsbauteilen verstanden werden. Insbesondere ist die geometrische Orientierung der zwei Hauptfunktionsbauteile durch einen gegenseitigen Abstand gekennzeichnet. Unter einem "Abstandselement" soll insbesondere ein von einer elektrischen Leitung differierendes Element verstanden werden, welches zwischen den zwei Hauptfunktionsbauteilen angeordnet ist und das vorzugsweise dazu vorgesehen ist, einen gegenseitigen Abstand zwischen den zwei Hauptfunktionsbauteilen festzulegen. Vorzugsweise bildet das Abstandselement ein Lagerelement, welches dazu vorgesehen ist, eines der Hauptfunktionsbauteile am anderen zu lagern und/oder zu befestigen. Darunter, dass die zwei Hauptfunktionsbauteile "für Wechselstromsignale elektrisch gekoppelt" sind, soll insbesondere verstanden werden, dass ein Wechselstromwiderstand zwischen den beiden Hauptfunktionsbauteilen einen endlichen Wert annimmt und dass vorteilhaft Wechselstromsignale vom ersten Hauptfunktionsbauteil zum zweiten Hauptfunktionsbauteil übertragen werden können. Darunter, dass die zwei Hauptfunktionsbauteile "im Wesentlichen durch eine Beabstandung" gekoppelt sind, soll insbesondere verstanden werden, dass hochfrequente Störsignale höchstens zu einem geringen Teil über von einer Beabstandung differierende Elemente zwischen den zwei Hauptfunktionsbauteilen übertragen werden. Darunter, dass "hochfrequente Störsignale höchstens zu einem geringen Teil über von einer Beabstandung differierende Elemente übertragen werden", soll insbesondere verstanden werden, dass höchstens 40%, insbesondere maximal 30%, vorteilhaft höchstens 20% und besonders vorteilhaft maximal 10% einer Gesamtleistung und/oder eines effektiven Gesamtstroms über von einer Beabstandung differierende Elemente übertragen werden. Hierdurch kann eine gemeinsame Entstörung der zwei Hauptfunktionsbauteile ermöglicht werden.

In einer besonders bevorzugten Ausgestaltung der Erfindung wird vorgeschlagen, dass die Hausgerätevorrichtung eine elektrische Leitung zwischen den zwei Hauptfunktionsbauteilen umfasst. Hierdurch kann ein identisches elektrisches Potential beider Hauptfunktionsbauteile erreicht werden. Insbesondere verbindet eine elektrische Leitung, die vorzugsweise in einem relevanten Frequenzband des Störsignals einen möglichst niedrigen Impedanzbetrag aufweist und besonders vorteilhaft als eine elektrische Leitung mit einer großen Oberfläche, insbesondere eine Litzenleitung, ausgeführt ist, die beiden Hauptfunktionsbauteile. Hierdurch kann ein Wechselstromwiderstand für hochfrequente Störsignale zwischen den Hauptfunktionsbauteilen vorteilhaft reduziert werden.

Vorteilhaft bildet das erste Hauptfunktionsbauteil zumindest einen Teil eines Außengehäuses eines Hausgeräts. Vorzugsweise umfasst das Hauptfunktionsbauteil das gesamte Außengehäuse des Hausgeräts. Unter einem "Außengehäuse" eines Hausgeräts ist hierbei eine metallische Gehäuseeinheit zu verstehen, die in einem montierten Zustand des Hausgeräts von einem Bediener anfassbar ist. Hierdurch kann eine Einstückigkeit einer Funktionserdung mit einer Schutzerdung ermöglicht werden. Vorzugsweise ist das Außengehäuse bei Verwendung in einem Induktionskochfeld aus einem unmagnetischen Metallblech, insbesondere einem Aluminiumblech, gebildet. Unter einem "unmagnetischen" Metall soll insbesondere ein Metall mit einer Permeabilitätszahl von höchstens 1,1 und vorteilhaft von höchstens 1,0001 verstanden werden. Hierdurch kann eine Wechselwirkung einer Außenwand des Außengehäuses mit einem hochfrequenten magnetischen Wechselfeld einer Heizeinheit minimiert werden.

Ferner wird vorgeschlagen, dass das zweite Hauptfunktionsbauteil zumindest teilweise eine Trägereinheit für wenigstens eine Heizeinheit bildet. Unter einer "Trägereinheit für wenigstens eine Heizeinheit" soll insbesondere eine, vorzugsweise plattenartige, metallische Baueinheit verstanden werden, an der in einem montierten Zustand wenigstens eine Heizeinheit, insbesondere ein Induktionsheizkörper, befestigt ist. Hierdurch kann eine Entstörung der Trägereinheit zur Einhaltung von EMV-Richtlinien, insbesondere bei einem Induktionskochfeld, ermöglicht werden. Vorzugsweise ist die Trägereinheit bei Verwendung in einem Induktionskochfeld aus einem unmagnetischen Metall, insbesondere Aluminium, gebildet. Hierdurch kann eine Wechselwirkung der Trägereinheit mit einem hochfrequenten magnetischen Wechselfeld der Heizeinheit minimiert werden.

Ferner wird ein Verfahren mit einer, insbesondere erfindungsgemäßen Hausgerätevorrichtung mit einem metallischen ersten Hauptfunktionsbauteil, zumindest einem metallischen zweiten Hauptfunktionsbauteil, zumindest zwei Hauptentstörungsleitungen und einer EMV-Filtereinheit vorgeschlagen, bei dem die zumindest zwei Hauptfunktionsbauteile über zwei zumindest teilweise einstückig ausgebildete Hauptentstörungsleitungen mittels der EMV-Filtereinheit entstört werden. Darunter, dass die Hauptfunktionsbauteile mittels der EMV-Filtereinheit "entstört" werden, soll insbesondere verstanden werden, dass eine Abschwächung einer Signalstärke eines hochfrequenten Störsignals um zumindest 20%, insbesondere um wenigstens 40% und vorteilhaft um mindestens 60% und besonders vorteilhaft unter eine gesetzlich vorgeschriebene und/oder durch Normen, insbesondere durch den Standard CISPR 11, definierte Signalobergrenze durchgeführt wird. Hierdurch kann kostengünstig eine Entstörung der beiden Hauptfunktionsbauteile erzielt werden.

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination.

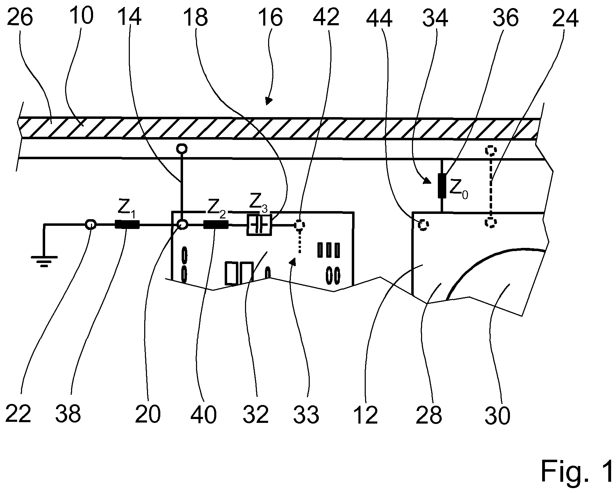

Fig. 1 zeigt eine schematische Darstellung eines Teils eines Induktionskochfelds mit einer Heizeinheit 30, einer Elektronikplatine 32 und einer Hausgerätevorrichtung mit einem metallischen ersten Hauptfunktionsbauteil 10, einem metallischen zweiten Hauptfunktionsbauteil 12, zwei Hauptentstörungsleitungen 14, 16 und einer EMV-Filtereinheit 18, die sich auf der Elektronikplatine 32 befindet und die unter anderem dazu vorgesehen ist, elektromagnetische Störsignale von Elektronikbaugruppen 33 auf der Elektronikplatine 32, insbesondere von Wechselrichtern, zu filtern. Das erste Hauptfunktionsbauteil 10 bildet ein metallisches Außengehäuse 26 des Induktionskochfelds und ist daher mit einer Schutzerdung versehen. Das zweite Hauptfunktionsbauteil 12 bildet eine Trägereinheit 28 aus Aluminiumblech für die Heizeinheit 30. Die Heizeinheit 30 ist auf die Trägereinheit 28 geschraubt. Die EMV-Filtereinheit 18 ist zu einer Entstörung der zwei Hauptfunktionsbauteile 10, 12 über eine erste Hauptentstörungsleitung 14 mit dem ersten Hauptfunktionsbauteil 10 und über eine zweite Hauptentstörungsleitung 16 mit dem zweiten Hauptfunktionsbauteil 12 verbunden. Die zweite Hauptentstörungsleitung 16 umfasst die gesamte erste Hauptentstörungsleitung 14, das erste Hauptfunktionsbauteil 10 und eine Beabstandung 34. Die Hauptentstörungsleitungen 14, 16 sind daher zumindest teilweise einstückig ausgebildet. Bei der Beabstandung 34 handelt es sich um elektrisch leitfähige Lagerelemente 36, die das zweite Hauptfunktionsbauteil 12 am ersten Hauptfunktionsbauteil 10 befestigen. Die zwei Hauptfunktionsbauteile 10, 12 sind durch die Beabstandung 34 für Wechselstromsignale und für Gleichstromsignale elektrisch gekoppelt. Die Lagerelemente 36 sind in Form von metallischen Federn ausgeführt und drücken das zweite Hauptfunktionsbauteil 12 zusammen mit der an ihr befestigten Heizeinheit 30 von unten gegen eine nicht dargestellte Kochfeldplatte. Die Lagerelemente 36 weisen für hochfrequente Störsignale einen relativ hohen Betrag einer komplexwertigen Impedanz Z₀ auf. Alternativ oder zusätzlich kann daher eine
elektrische Leitung 24 mit einem niedrigeren Impedanzbetrag im relevanten Frequenzband, insbesondere ein Flachleiter, zwischen den zwei Hauptfunktionsbauteilen 10, 12 vorgesehen sein. Die Hausgerätevorrichtung umfasst ferner einen auf der Elektronikplatine 32 aufgebrachten Leitungsknoten 20, der die EMV-Filtereinheit 18, eine Schutzleiteranschlussstelle 22 einer Hauptspannungsversorgung und das erste Hauptfunktionsbauteil 10 verknüpft. Demnach sind beide Hauptfunktionsbauteile 10, 12 und die EMV-Filtereinheit 18 geerdet, wobei die Erdung sowohl eine Schutz- als auch eine Funktionserdung darstellt.

Die Heizeinheit 30 wird bei einem Heizbetrieb in bekannter Weise mit einem Wechselstrom mit einer Frequenz im Bereich von 20 kHz bis 50 kHz betrieben, der von einem auf der Elektronikplatine 32 angeordneten Wechselrichter bereitgestellt wird. Im zweiten Hauptfunktionsbauteil 12 werden hierbei hochfrequente Störsignale induziert, die zur Erfüllung von EMV-Richtlinien einer EMV-Filtereinheit 18 zugeführt werden müssen. Hierzu wurde bei Induktionskochfeldern aus dem Stand der Technik das zweite Hauptfunktionsbauteil 12 über eine Hauptentstörungsleitung zwischen einer ersten Anschlussstelle 42 der Elektronikplatine 32 und einer zweiten Anschlussstelle 44 des zweiten Hauptfunktionsbauteils 12 direkt mit der EMV-Filtereinheit 18 verbunden, so dass die hochfrequenten Störsignale des zweiten Hauptfunktionsbauteils 12 in der EMV-Filtereinheit 18 gefiltert wurden. Diese Hauptentstörungsleitung zwischen der ersten Anschlussstelle 42 und der zweiten Anschlussstelle 44 kann bei einer erfindungsgemäßen Hausgerätevorrichtung entfallen oder alternativ durch elektrische Leitungen 24 ersetzt werden, die die zwei Hauptfunktionsbauteile 10, 12 miteinander verbinden und die eine flexiblere Montage erlauben. Bei der erfindungsgemäßen Hausgerätevorrichtung gelangen die hochfrequenten Störsignale über die Beabstandung 34 oder alternativ über die elektrische Leitung 24 vom zweiten Hauptfunktionsbauteil 12 zum ersten Hauptfunktionsbauteil 10. Über die erste Hauptentstörungsleitung 14 gelangen die hochfrequenten Störsignale zum Leitungsknoten 20 auf der Elektronikplatine 32, von dem aus zwei weitere elektrische Leitungen abgehen. Ein Kabel 38 mit einer komplexwertigen Impedanz Z₁ führt vom Leitungsknoten 20 zur Schutzleiteranschlussstelle 22. Eine Leiterbahn 40 mit einer komplexwertigen Impedanz Z₂ führt auf der Elektronikplatine 32 vom Leitungsknoten 20 zur EMV-Filtereinheit 18, die über eine komplexwertige Impedanz Z₃ verfügt. Die induktiv geprägte komplexwertige Impedanz Z₁ weist einen positiven Imaginärteil auf, während die kapazitiv geprägten komplexwertigen Impedanzen Z₂ und Z₃ einen negativen Imaginärteil aufweisen. Da für hochfrequente Störsignale ein Betrag der komplexwertigen Impedanz Z₁ deutlich größer ist als ein Betrag der Summe der komplexwertigen Impedanzen Z₂ und Z₃, wählt das hochfrequente Störsignal bevorzugt den Weg durch die EMV-Filtereinheit 18 und wird gefiltert. Niederfrequente Signale und Gleichstromsignale wählen hingegen bevorzugt den Weg zur Schutzleiteranschlussstelle 22.

Bei dem in Fig. 1 teilweise dargestellten Induktionskochfeld kommt ein Verfahren mit einer Hausgerätevorrichtung mit einem metallischen ersten Hauptfunktionsbauteil 10, zumindest einem metallischen zweiten Hauptfunktionsbauteil 12, zumindest zwei Hauptentstörungsleitungen 14, 16 und einer EMV-Filtereinheit 18 zum Einsatz, bei dem die zumindest zwei Hauptfunktionsbauteile 10, 12 über zwei zumindest teilweise einstückig ausgebildete Hauptentstörungsleitungen 14, 16 mittels der EMV-Filtereinheit 18 entstört werden, so dass das Induktionskochfeld als Ganzes dem Standard CISPR 11 genügt.

### Bezugszeichen

- 10: erstes Hauptfunktionsbauteil
- 12: zweites Hauptfunktionsbauteil
- 14: Hauptentstörungsleitung
- 16: Hauptentstörungsleitung
- 18: EMV-Filtereinheit
- 20: Leitungsknoten
- 22: Schutzleiteranschlussstelle
- 24: elektrische Leitung
- 26: Außengehäuse
- 28: Trägereinheit
- 30: Heizeinheit
- 32: Elektronikplatine
- 33: Elektronikbaugruppen
- 34: Beabstandung
- 36: Lagerelemente
- 38: Kabel
- 40: Leiterbahn
- 42: erste Anschlussstelle
- 44: zweite Anschlussstelle
- Z₀: Impedanz
- Z₁: Impedanz
- Z₂: Impedanz
- Z₃: Impedanz

## Patentansprüche

1. Hausgerätevorrichtung mit einem metallischen ersten Hauptfunktionsbauteil (10), welches zumindest einen Teil eines Außengehäuses (26) eines Hausgeräts bildet, zumindest einem metallischen zweiten Hauptfunktionsbauteil (12), welches zumindest teilweise eine Trägereinheit (28) für wenigstens eine Heizeinheit (30) bildet, zumindest zwei Hauptentstörungsleitungen (14, 16) und einer EMV-Filtereinheit (18), die zumindest zu einer Entstörung über eine erste Hauptentstörungsleitung (14) mit dem ersten Hauptfunktionsbauteil (10) und über eine zweite Hauptentstörungsleitung (16) mit dem zweiten Hauptfunktionsbauteil (12) verbunden ist, **dadurch gekennzeichnet, dass** die Hauptentstörungsleitungen (14, 16) zumindest teilweise einstückig ausgebildet sind, wobei unter zumindest teilweise einstückig verstanden werden soll, dass die Hauptentstörungsleitungen (14, 16) zumindest einen gemeinsamen Teilbereich aufweisen.

2. Hausgerätevorrichtung nach Anspruch 1, **dadurch gekennzeichnet, dass** zumindest eines der zwei Hauptfunktionsbauteile (10) geerdet ist.

3. Hausgerätevorrichtung nach Anspruch 2, **gekennzeichnet durch** einen Leitungsknoten (20), der die EMV-Filtereinheit (18), eine Schutzleiteranschlussstelle (22) einer Hauptspannungsversorgung und das erste Hauptfunktionsbauteil (10) verknüpft.

4. Hausgerätevorrichtung nach einem der vorhergehenden Ansprüche, **dadurch gekennzeichnet, dass** die zwei Hauptfunktionsbauteile (10, 12) im Wesentlichen durch eine Beabstandung (34) zumindest für Wechselstromsignale elektrisch gekoppelt sind.

5. Hausgerätevorrichtung nach einem der vorhergehenden Ansprüche, **gekennzeichnet durch** eine elektrische Leitung (24) zwischen den zwei Hauptfunktionsbauteilen (10, 12).

6. Hausgerät, insbesondere Induktionskochfeld, mit einer Hausgerätevorrichtung nach einem der vorhergehenden Ansprüche.

7. Verfahren zur Montage einer Hausgerätevorrichtung mit einem metallischen ersten Hauptfunktionsbauteil (10), welches zumindest einen Teil eines Außengehäuses (26) eines Hausgeräts bildet, zumindest einem metallischen zweiten Hauptfunktionsbauteil (12), welches zumindest teilweise eine Trägereinheit (28) für wenigstens eine Heizeinheit (30) bildet, zumindest zwei Hauptentstörungsleitungen (14, 16) und einer EMV-Filtereinheit (18), nach einem der Ansprüche 1 bis 5, **dadurch gekennzeichnet, dass** die zumindest zwei Hauptfunktionsbauteile (10, 12) über zwei zumindest teilweise einstückig ausgebildete Hauptentstörungsleitungen (14, 16), wobei unter zumindest teilweise einstückig verstanden werden soll, dass die Hauptentstörungsleitungen zumindest einen gemeinsamen Teilbereich aufweisen, mittels der EMV-Filtereinheit (18) entstört werden.

## Claims

1. Domestic appliance device having a metallic first main functional component (10), which forms at least one part of an external housing (26) of a domestic appliance device, at least one metallic second main functional component (12), which at least partially forms a support unit (28) for at least one heating unit (30), at least two main suppression lines (14, 16) and an EMC filter unit (18), which at least for suppression is connected by way of a first main suppression line (14) to the first main functional component (10) and by way of a second main suppression line (16) to the second main functional component (12), **characterised in that** the main suppression lines (14, 16) are embodied at least partially in one piece, wherein at least partially in one piece is to be understood to mean that the main suppression lines (14, 16) have at least one shared subarea.

2. Domestic appliance device according to claim 1, **characterised in that** at least one of the two main functional components (10) is earthed.

3. Domestic appliance device according to claim 2, **characterised by** a line node (20), which links the EMC filter unit (18), a protective conductor connecting point (22) of a main voltage supply and the first main functional component (10).

4. Domestic appliance device according to one of the preceding claims, **characterised in that** the two main functional components (10, 12) are electrically coupled substantially by forming a gap (24) at least for alternating current signals.

5. Domestic appliance device according to one of the preceding claims, **characterised by** an electric line (24) between the two main functional components (10, 12).

6. Domestic appliance, in particular induction hob, with a domestic appliance device according to one of the preceding claims.

7. Method for assembling a domestic appliance device having a metallic first main functional component (10), which forms at least one part of an external housing (26) of a domestic appliance device, at least one metallic second main functional component (12), which at least partially forms a support unit (28) for at least one heating unit (30), at least two main suppression lines (14, 16) and an EMC filter unit (18) according to one of claims 1 to 5, **characterised in that** the at least two main functional components (10, 12) are suppressed by means of the EMC filter unit (18) by way of two main suppression lines (14, 16) embodied at least partially in one piece, wherein at least partially in one piece is to be understood to mean that the main suppression lines have at least one shared subarea.

## Revendications

1. Dispositif d'appareil ménager comprenant un premier composant fonctionnel principal (10) métallique, lequel forme au moins une partie d'un boîtier extérieur (26) d'un appareil ménager, comprenant au moins un deuxième composant fonctionnel principal (12) métallique, lequel forme au moins en partie une unité de support (28) pour au moins une unité de chauffage (30), comprenant au moins deux lignes de déparasitage principales (14, 16) et une unité de filtrage CEM (18), laquelle, au moins pour un déparasitage, est reliée au premier composant fonctionnel principal (10) par l'intermédiaire d'une première ligne de déparasitage principale (14) et au deuxième composant fonctionnel principal (12) par l'intermédiaire d'une deuxième ligne de déparasitage principale (16), **caractérisé en ce que** les lignes de déparasitage principales (14, 16) sont réalisées au moins en partie d'une seule pièce, sachant que par réalisées au moins en partie d'une seule pièce, on entend que les lignes de déparasitage principales (14, 16) présentent au moins une zone partielle commune.

2. Dispositif d'appareil ménager selon la revendication 1, **caractérisé en ce qu'**au moins un des deux composants fonctionnels principaux (10) est mis à la terre.

3. Dispositif d'appareil ménager selon la revendication 2, **caractérisé par** un noeud de lignes (20) qui relie l'unité de filtrage CEM (18), un point de raccordement de conducteur de protection (22) d'une alimentation principale en tension et le premier composant fonctionnel principal (10).

4. Dispositif d'appareil ménager selon l'une quelconque des revendications précédentes, **caractérisé en ce que** les deux composants fonctionnels principaux (10, 12) sont électriquement couplés au moins pour les signaux de courant alternatif essentiellement au moyen d'un espacement (34).

5. Dispositif d'appareil ménager selon l'une quelconque des revendications précédentes, **caractérisé par** une ligne électrique (24) entre les deux composants fonctionnels principaux (10, 12).

6. Appareil ménager, notamment table de cuisson à induction, comprenant un dispositif d'appareil ménager selon l'une quelconque des revendications précédentes.

7. Procédé de montage d'un dispositif d'appareil ménager comprenant un premier composant fonctionnel principal (10) métallique, lequel forme au moins une partie d'un boîtier extérieur (26) d'un appareil ménager, comprenant au moins un deuxième composant fonctionnel principal (12) métallique, lequel forme au moins en partie une unité de support (28) pour au moins une unité de chauffage (30), comprenant au moins deux lignes de déparasitage principales (14, 16) et une unité de filtrage CEM (18) selon l'une quelconque des revendications 1 à 5, **caractérisé en ce que** les aux moins deux composants fonctionnels principaux (10, 12) sont déparasités au moyen de l'unité de filtrage CEM (18) par l'intermédiaire de deux lignes de déparasitage principales (14, 16) réalisées au moins en partie d'une seule pièce, sachant que par réalisées au moins en partie d'une seule pièce, on entend que les lignes de déparasitage principales (14, 16) présentent au moins une zone partielle commune.
